# EUROPEAN PATENT SPECIFICATION

(11) **EP 3 789 781 B1**
(45) Date of publication and mention of the grant of the patent: **27.09.2023**
(21) Application number: 19195867.7
(22) Date of filing: 06.09.2019
(51) Int. Cl.: G01R 31/66

(54) **ANTENNA ASSEMBLY**
ANTENNENANORDNUNG
SYSTÈME D'ANTENNES

(43) Date of publication of application: 10.03.2021
(73) Proprietor: Valeo Comfort and Driving Assistance, 94000 Créteil (FR)
(72) Inventor: KNOESS, Henning, 94046 Créteil CEDEX (FR); SHANBHAG, Jagannath, 94046 Créteil CEDEX (FR)
(74) Representative: Delaval, Guillaume Laurent

(56) References cited:
- WO-A2-2005/094154
- JP-A- 2014 187 548
- US-A1- 2005 174 292
- US-A1- 2016 283 838
- US-A1- 2018 052 195
- Quectel: "M10 Antenna Detection Application Circuit", , 26 June 2012 (2012-06-26), XP055671945, EddyWireless website Retrieved from the Internet: URL:https://www.eddywireless.com/yahoo_sit e_admin/assets/docs/Quectel_GSM_Antanna_De tection_Application_note.175173113.pdf [retrieved on 2020-02-27]

## Description

### BACKGROUND INFORMATION AND PRIOR ART

It is known to provide antenna assemblies with a diagnosis circuit configured to inject a direct current into the antenna or into a dedicated resistor placed before the antenna matching circuit, so as to test the correct positioning and/or connection of the antenna. Some known antenna assemblies with the corresponding antenna diagnosis circuits are found in JP 2014 187548 A, US 2005/174292 A1, WO 2005/094154 A2 and US 2018/052195 A1.

To enable the corresponding current flow in the antenna or the resistor, the antenna (or its matching circuit) is conventionally connected to the diagnosis circuit via two distinct connecting elements (one for injecting the direct current into the antenna or resistor, and the other one for providing a return path for this direct current to the diagnosis circuit).

### SUMMARY OF THE INVENTION

In this context, the invention provides an antenna assembly comprising:
- a substrate carrying a first contact pad and a second contact pad, the first contact pad and the second contact pad being electrically conductive and insulated from each other on the substrate;
- an antenna;
- a conductive element for connecting the antenna to the first contact pad and positioned in physical contact with the first contact pad and with the second contact pad;
- a radiofrequency circuit connected to the first contact pad; and
- a diagnosis circuit configured to test a conducting path via the first contact pad and the second contact pad,
wherein the conductive element is configured to establish a conducting path between the first contact pad and the second contact pad, the conductive element being compressible and made of a conductive elastomer.

Thus, when the antenna and hence the conductive element are correctly positioned, a conducting path is established via the first contact pad, the conductive element and the second contact pad, which conducting path may then be used by the diagnosis circuit to confirm correct positioning and connection of the antenna.

According to possible optional features:
- the conductive element is held between the antenna and respective external surfaces of the first and second contact pads;
- the radiofrequency circuit is connected to the first contact pad by a radiofrequency feed;
- the diagnosis circuit is configured to inject current in the radiofrequency feed;
- the second contact pad is connected to a conductive track for providing a return path for said current;
- a first resistor (or a first inductor, *e.g.* having an impedance larger than 1 kΩ in the radiofrequency range used by the radiofrequency circuit) is interposed between the radiofrequency feed and a first circuit portion;
- the diagnosis circuit is configured to apply a (DC) voltage to said first circuit portion;
- a second resistor (or a second inductor, e.g. having an impedance larger than 1 kΩ in the radiofrequency range used by the radiofrequency circuit) is interposed between the second contact pad and a second circuit portion;
- said second circuit portion is grounded (*i.e.* electrically connected to a common ground electric potential to which the diagnosis circuit is also electrically connected);
- a high pass filter (*e.g.* a capacitive circuit) is connected (here interposed) between the radiofrequency circuit and the radiofrequency feed;
- the antenna is a monopole antenna.

The antenna and the conductive element may be provided as distinct parts, for instance. However, according to a possible variation, the antenna and the conductive element may be formed integral with each other, *i.e.* as two respective portions of the same object.

Other features and advantages of the embodiments of the present invention will be better understood upon reading of preferred embodiments thereof with reference to the appended drawings.

### BRIEF DESCRIPTION OF THE DRAWINGS

Figure 1 shows a printed circuit board of an exemplary embodiment of an antenna assembly according to the invention.
Figure 2 is a cross section showing the printed circuit board of Figure 1, a conductive element and an antenna included in this antenna assembly.
Figure 3 schematically shows a possible variation for the configuration of contact pads of the printed circuit board.

### DETAILED DESCRIPTION OF EXAMPLE(S)

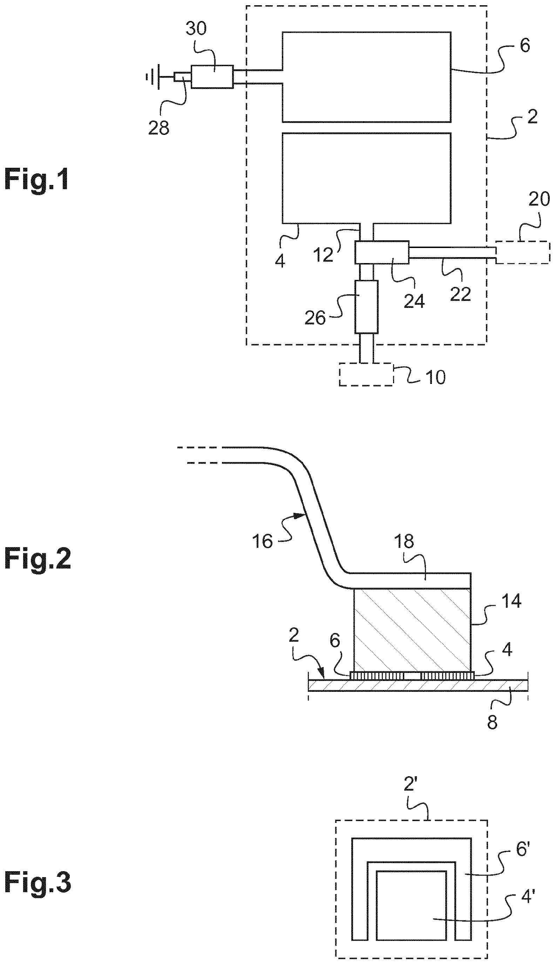

An exemplary embodiment of an antenna assembly according to the invention is now described referring in particular to Figures 1 & 2.

The antenna assembly comprises a printed circuit board 2 including a non-conductive substrate 8 and two electrically conductive contact pads 4, 6 carried by the substrate 8. Other pads and tracks are also defined on this substrate 8, in particular as further explained below.

The contact pads 4, 6 are each formed for instance by a copper layer deposited on an insulating material forming the substrate 8 of the printed circuit board 2.

The substrate 8 may be made from an epoxy resin, in which case the printed circuit board 2 is relatively rigid. In other embodiments however, the printed circuit board may be flexible (the substrate being made in this case of a flexible foil, for instance).

The two contact pads 4, 6 are separate from each other on the substrate (i.e. within the printed circuit board 2), *i.e.* the contact pads 4, 6 are situated at a distance from each other, such that the two contact pads are insulated from each other on the substrate 8, *i.e.* at the level of the printed circuit board 2.

In the embodiment of Figure 1, the two contact pads 4, 6 have each a rectangular shape. At least one of the two contact pads may however have a different shape, as visible for instance in the possible variation shown in Figure 3 (including a first contact pad 4' and a second contact pad 6', the second contact pad 6' partly surrounding the first contact pad 4' but remaining insulated from the first contact pad 4' at the level of the printed circuit board 2').

One of the two contact pads, referred to hereinafter as the first contact pad 4, is connected to a radiofrequency circuit 10, here via a radiofrequency feed 12.

In the present case, as shown in Figure 1, the radiofrequency feed 12 is a conductive track formed on the printed circuit board 2 extending from (and thus in contact with) the first contact pad 4. Other configurations for connecting the concerned contact pad (here the first contact pad 4) to the radiofrequency circuit 10 are however possible, for instance through a via formed in the printed circuit board 2 (the concerned contact pad being situated in this case in a layer of the printed circuit board and being connected to circuits formed in another layer of the printed circuit board, these circuits possibly including the radiofrequency circuit).

As visible in Figure 2, the antenna assembly also includes an (electrically) conductive element 14 and an antenna 16, here a monopole antenna.

The conductive element 14 is interposed between the first contact pad 4 and the antenna 16, and thereby connects the antenna 16 to the first contact pad 4.

In the present example, the conductive element 14 is compressible. The conductive element 14 may thus be held (under compression) between the monopole antenna 16 and the first contact pad 4, here between a planar portion 18 of the antenna 16 and the first contact pad 4.

As visible in Figure 2, the planar portion 18 forms in the present case a free end of the antenna 16. In the present example, this free end of the antenna 16 thus contacts the conductive element 14.

In practice, the conductive element 14 may be made of a conductive elastomer. The conductive element 14 is here a block of conductive elastomer.

As visible in Figure 2, the conductive element 14 is in physical contact not only with the first contact pad 4 as just mentioned, but also with the other one of the contact pads, referred to hereinafter as the second contact pad 6.

The conductive element 14 is thus interposed not only between the first contact pad 4 and the antenna 16, but also between the second contact pad 6 and the antenna 16.

Because of this physical contact with both the first and second contact pads 4, 6, the conductive element 14 establishes an electrical connection (*i.e.* a conducting path) between the first contact pad 4 and the second contact pad 6.

As visible in Figure 2, in the present example, the conductive element 14 is thus held (here under compression) between the antenna 16 (here a free end of the antenna 16, forming for instance a planar portion 18) and a plane formed by respective external surfaces of the first and second contact pads 4, 6.

The radiofrequency circuit 10 is designed to apply radiofrequency signals to the antenna 16 and/or to receive radiofrequency signals from the antenna 16, in both cases via the conductive element 14, the first contact pad 4 and the radiofrequency feed 12. In the present case, the radiofrequency signals have frequencies between 100 MHz and 10 GHz. The invention also applies in other frequency ranges, however.

The antenna assembly also comprises a diagnosis circuit 20 configured to test a conducting path via the first contact pad 4 and the second contact pad 6 (i.e. the closure of this conducting path via the first contact pad 4 and the second contact pad 6).

The printed circuit board 2 includes a conductive track 22 (called hereinafter a bias conductive track 22), forming a first circuit portion, and a first resistor 24 interposed between the radiofrequency feed 12 and the bias conductive track 22. The first resistor 24 has a resistance between 1 kΩ and 100 kΩ, for instance. In other embodiments, the first resistor 24 could be replaced with an inductor having a high impedance (*e.g.* an impedance larger than 1 kΩ) in the concerned radiofrequency range, *i.e.* the frequency range used by the radiofrequency circuit 10, here between 100 MHz and 10 GHz).

The diagnosis circuit 20 is in electrical contact with the bias conductive track 22 and applies a voltage (here a DC voltage, *e.g.* between 1 V and 10 V) to the bias conductive track 22.

Thanks to this construction, the diagnosis circuit 20 may inject current (here a direct current) in the radiofrequency feed 12 (provided a return path for the current is present, as explained below).

In order to protect the radiofrequency circuit 10 from this current, a high pass filter 26 (including for instance a capacitive element) is connected between the radiofrequency circuit 10 and the radiofrequency feed 12.

The printed circuit board 2 also includes a conductive track 28 (called hereinafter a grounded conductive track 28), forming a second circuit portion, and a second resistor 30 interposed between the second contact pad 6 and the grounded conductive track 28. The second resistor 30 has a resistance between 1 kΩ and 100 kΩ, for instance. In other embodiments, the second resistor 30 could be replaced with an inductor having a high impedance (*e.g.* an impedance larger than 1 kΩ) in the concerned radiofrequency range, *i.e.* the frequency range used by the radiofrequency circuit 10, here between 100 MHz and 10 GHz).

The grounded conductive track 28 is connected to ground. Consequently, when an electrical connection is established between the first contact pad 4 and the second contact pad 6 thanks to the conductive element 14 (as explained above), the grounded conductive track 28 provides a return path for the current injected in the radiofrequency feed 12 (and thus in the first contact pad 4) by the diagnosis circuit 20 (which is also connected to ground).

Thanks to the above construction, if the (here monopole) antenna 16 and the conductive element 14 are correctly positioned, the conducting path via the first contact pad 4 and the second contact pad 6 is closed and the diagnosis circuit 20 can therefore detect this closure of the conducting path via the first contact pad 4 and the second contact pad 6 and, for instance, send an item of information (represented e.g. by an electrical signal or data) indicative of correct positioning of the antenna 16 to an electronic circuit (external to the antenna assembly and not shown in the Figures). This electronic circuit may for instance be an electronic control unit situated on board a vehicle when the antenna assembly is used in such a vehicle.

However, if the antenna 16 is not correctly positioned within the antenna assembly (and does not therefore press upon the conductive element 14) or the conductive element 14 is not correctly positioned to establish the connection between the first contact pad 4 and the antenna 16, the conducting path via the first contact pad 4 and the second contact pad 6 is open, which is detected by the diagnosis circuit 20. The diagnosis circuit 20 may for instance in this case send an item of information (represented e.g. by an electrical signal or date) indicative of disconnection of the antenna 16 to the (external) electronic circuit mentioned above.

Thus, a diagnosis of the presence and correct connection of the antenna 16 is provided, while possibly using a single conductive element (thus reducing cost) and without creating a complex return path which would inevitably interfere with the antenna radiofrequency performance.

In the examples described above, the antenna and the conductive element are presented as separate parts. The conductive element may in practice be affixed (*e.g.* glued, in particular when the conductive element is made of conductive elastomer) to the antenna. In addition, in other possible embodiments, the conductive element (contacting the first contact pad and the second contact pad) may be made integral with the antenna. The free end of the part (or object) including the antenna may in this case be configured as a spring contact (this spring contact forming the conductive element), in particular when this part (or object) is made of sheet metal.

## Claims

1. Antenna assembly comprising:
- a substrate (8) carrying a first contact pad (4) and a second contact pad (6), the first contact pad (4) and the second contact pad (6) being electrically conductive and insulated from each other on the substrate (8);
- an antenna (16);
- a conductive element (14) for connecting the antenna (16) to the first contact pad (4) and positioned in physical contact with the first contact pad (4) and with the second contact pad (6);
- a radiofrequency circuit (10) connected to the first contact pad (4); and
- a diagnosis circuit (20) configured to test a conducting path via the first contact pad (4) and the second contact pad (6),
wherein the conductive element (14) is configured to establish a conducting path between the first contact pad (4) and the second contact pad (6),
**characterized in that**
the conductive element (14) is compressible and made of a conductive elastomer.

2. Antenna assembly according to claim 1, wherein the conductive element (14) is held between the antenna (16) and respective external surfaces of the first and second contact pads (4, 6).

3. Antenna assembly according to any of claims 1 to 3, wherein the radiofrequency circuit (10) is connected to the first contact pad (4) by a radiofrequency feed (12).

4. Antenna assembly according to claim 3, wherein the diagnosis circuit (20) is configured to inject current in the radiofrequency feed (12).

5. Antenna assembly according to claim 4, wherein the second contact pad (6) is connected to a conductive track (28) for providing a return path for said current.

6. Antenna assembly according to any of claims 3 to 5, wherein a first resistor (24) is interposed between the radiofrequency feed (12) and a first circuit portion (22), and wherein the diagnosis circuit (20) is configured to apply a voltage to said first circuit portion (22).

7. Antenna assembly according to any of claims 3 to 5, wherein a first inductor is interposed between the radiofrequency feed (12) and a first circuit portion (22), the first inductor having an impedance larger than 1 kΩ in a radiofrequency range used by the radiofrequency circuit, and wherein the diagnosis circuit (20) is configured to apply a voltage to said first circuit portion (22).

8. Antenna assembly according to any of claims 3 to 7, wherein a high pass filter (26) is connected between the radiofrequency circuit (10) and the radiofrequency feed (12).

9. Antenna assembly according to any of claims 1 to 8, wherein a second resistor (30) is interposed between the second contact pad (6) and a second circuit portion (28), and wherein said second circuit portion (28) is grounded.

10. Antenna assembly according to any of claims 1 to 8, wherein a second inductor is interposed between the second contact pad (6) and a second circuit portion (28), the second inductor having an impedance larger than 1 kΩ in a radiofrequency range used by the radiofrequency circuit, and wherein said second circuit portion (28) is grounded.

11. Antenna assembly according to any of claims 1 to 10, wherein the antenna (16) is a monopole antenna.

## Patentansprüche

1. Antennenanordnung umfassend:
- ein Substrat (8), das eine erste Kontaktfläche (4) und eine zweite Kontaktfläche (6) trägt, wobei die erste Kontaktfläche (4) und die zweite Kontaktfläche (6) elektrisch leitend und voneinander auf dem Substrat (8) isoliert sind;
- eine Antenne (16);
- ein leitendes Element (14) zum Verbinden der Antenne (16) mit der ersten Kontaktfläche (4), die in physischem Kontakt mit der ersten Kontaktfläche (4) und mit der zweiten Kontaktfläche (6) angeordnet ist;
- eine Hochfrequenzschaltung (10), die mit der ersten Kontaktfläche (4) verbunden ist; und
- eine Diagnoseschaltung (20), die dazu ausgelegt ist, einen Leitungspfad über die erste Kontaktfläche (4) und die zweite Kontaktfläche (6) zu prüfen,
wobei das leitende Element (14) dazu ausgelegt ist, einen leitenden Pfad zwischen der ersten Kontaktfläche (4) und der zweiten Kontaktfläche (6) herzustellen,
**dadurch gekennzeichnet, dass**
das leitende Element (14) komprimierbar ist und aus einem leitenden Elastomer besteht.

2. Antennenanordnung nach Anspruch 1, wobei das leitende Element (14) zwischen der Antenne (16) und den jeweiligen Außenflächen der ersten und zweiten Kontaktflächen (4, 6) gehalten wird.

3. Antennenanordnung nach einem der Ansprüche 1 bis 3, wobei die Hochfrequenzschaltung (10) über eine Hochfrequenzzuführung (12) mit der ersten Kontaktfläche (4) verbunden ist.

4. Antennenanordnung nach Anspruch 3, wobei die Diagnoseschaltung (20) dazu ausgelegt ist, Strom in die Hochfrequenzzuführung (12) einzuspeisen.

5. Antennenanordnung nach Anspruch 4, wobei die zweite Kontaktfläche (6) mit einer Leiterbahn (28) verbunden ist, um einen Rückweg für den Strom bereitzustellen.

6. Antennenanordnung nach einem der Ansprüche 3 bis 5, wobei ein erster Widerstand (24) zwischen der Hochfrequenzzuführung (12) und einem ersten Schaltungsabschnitt (22) zwischengeschaltet ist, und wobei die Diagnoseschaltung (20) dazu ausgelegt ist, eine Spannung an den ersten Schaltungsabschnitt (22) anzulegen.

7. Antennenanordnung nach einem der Ansprüche 3 bis 5, wobei eine erste Induktivität zwischen der Hochfrequenzzuführung (12) und einem ersten Schaltungsabschnitt (22) angeordnet ist, wobei die erste Induktivität eine Impedanz von mehr als 1 kΩ in einem von der Hochfrequenzschaltung verwendeten Hochfrequenzbereich aufweist, und wobei die Diagnoseschaltung (20) dazu ausgelegt ist, eine Spannung an den ersten Schaltungsabschnitt (22) anzulegen.

8. Antennenanordnung nach einem der Ansprüche 3 bis 7, wobei ein Hochpassfilter (26) zwischen die Hochfrequenzschaltung (10) und die Hochfrequenzzuführung (12) geschaltet ist.

9. Antennenanordnung nach einem der Ansprüche 1 bis 8, wobei ein zweiter Widerstand (30) zwischen der zweiten Kontaktfläche (6) und einem zweiten Schaltungsabschnitt (28) angeordnet ist, und wobei der zweite Schaltungsabschnitt (28) geerdet ist.

10. Antennenanordnung nach einem der Ansprüche 1 bis 8, wobei eine zweite Induktivität zwischen der zweiten Kontaktfläche (6) und einem zweiten Schaltungsabschnitt (28) zwischengeschaltet ist, wobei die zweite Induktivität eine Impedanz von mehr als 1 kΩ in einem Hochfrequenzbereich aufweist, der von der Hochfrequenzschaltung verwendet wird, und wobei der zweite Schaltungsabschnitt (28) geerdet ist.

11. Antennenanordnung nach einem der Ansprüche 1 bis 10, wobei die Antenne (16) eine Monopolantenne ist.

## Revendications

1. Ensemble d'antenne comprenant :
- un substrat (8) portant un premier plot de contact (4) et un second plot de contact (6), le premier plot de contact (4) et le second plot de contact (6) étant électriquement conducteurs et isolés l'un de l'autre sur le substrat (8) ;
- une antenne (16) ;
- un élément conducteur (14) pour connecter l'antenne (16) au premier plot de contact (4) et positionné en contact physique avec le premier plot de contact (4) et avec le second plot de contact (6) ;
- un circuit radiofréquence (10) connecté au premier plot de contact (4) ; et
- un circuit de diagnostic (20) configuré pour tester un chemin conducteur par l'intermédiaire du premier plot de contact (4) et du second plot de contact (6),
où l'élément conducteur (14) est configuré pour établir un chemin conducteur entre le premier plot de contact (4) et le second plot de contact (6),
**caractérisé en ce que** :
l'élément conducteur (14) est compressible et constitué d'un élastomère conducteur.

2. Ensemble d'antenne selon la revendication 1, dans lequel l'élément conducteur (14) est maintenu entre l'antenne (16) et les surfaces externes respectives des premier et second plots de contact (4, 6).

3. Ensemble d'antenne selon l'une quelconque des revendications 1 et 2, dans lequel le circuit radiofréquence (10) est connecté au premier plot de contact (4) par une alimentation radiofréquence (12).

4. Ensemble d'antenne selon la revendication 3, dans lequel le circuit de diagnostic (20) est configuré pour injecter du courant dans l'alimentation radiofréquence (12) .

5. Ensemble d'antenne selon la revendication 4, dans lequel le second plot de contact (6) est connecté à une piste conductrice (28) pour fournir un chemin de retour pour ledit courant.

6. Ensemble d'antenne selon l'une quelconque des revendications 3 à 5, dans lequel une première résistance (24) est intercalée entre l'alimentation radiofréquence (12) et une première partie de circuit (22), et où le circuit de diagnostic (20) est configuré pour appliquer une tension à ladite première partie de circuit (22).

7. Ensemble d'antenne selon l'une quelconque des revendications 3 à 5, dans lequel un premier inducteur est interposé entre l'alimentation radiofréquence (12) et une première partie de circuit (22), le premier inducteur ayant une impédance supérieure à 1 kΩ dans une plage de radiofréquences utilisée par le circuit radiofréquence, et où le circuit de diagnostic (20) est configuré pour appliquer une tension à ladite première partie de circuit (22).

8. Ensemble d'antenne selon l'une quelconque des revendications 3 à 7, dans lequel un filtre passe-haut (26) est connecté entre le circuit radiofréquence (10) et l'alimentation radiofréquence (12).

9. Ensemble d'antenne selon l'une quelconque des revendications 1 à 8, dans lequel une seconde résistance (30) est interposée entre le second plot de contact (6) et une seconde partie de circuit (28), et où ladite seconde partie de circuit (28) est mise à la terre.

10. Ensemble d'antenne selon l'une quelconque des revendications 1 à 8, dans lequel un second inducteur est interposé entre le second plot de contact (6) et une seconde partie de circuit (28), le second inducteur ayant une impédance supérieure à 1 kΩ dans une plage de radiofréquences utilisée par le circuit radiofréquence, et où ladite seconde partie de circuit (28) est mise à la terre.

11. Ensemble d'antenne selon l'une quelconque des revendications 1 à 10, dans lequel l'antenne (16) est une antenne unipolaire.
